(19) Europäisches Patentamt
European Patent Office
Office européen des brevets

(11) EP 2 395 596 A1

(12) # EUROPEAN PATENT APPLICATION
published in accordance with Art. 153(4) EPC

(43) Date of publication:
**14.12.2011 Bulletin 2011/50**

(21) Application number: **10738479.4**

(22) Date of filing: **29.01.2010**

(51) Int Cl.:
***H01M 14/00*** (2006.01) ***C09K 3/10*** (2006.01)
***H01L 31/04*** (2006.01) ***H01M 2/08*** (2006.01)

(86) International application number:
**PCT/JP2010/051268**

(87) International publication number:
**WO 2010/090145 (12.08.2010 Gazette 2010/32)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **03.02.2009 JP 2009022085**

(71) Applicant: **Threebond Co., Ltd.**
**Hachioji-shi, Tokyo 193-8533 (JP)**

(72) Inventors:
- **KANEKO, Koichi**
**Hachioji-shi**
**Tokyo 193-8533 (JP)**
- **AKASAKA, Hidefumi**
**Hachioji-shi**
**Tokyo 193-8533 (JP)**

(74) Representative: **Chapman, Paul William et al**
**Kilburn & Strode LLP**
**20 Red Lion Street**
**London**
**WC1R 4PJ (GB)**

(54) **SEALING AGENT COMPOSITION FOR DYE-SENSITIZED SOLAR CELL**

(57) [Problems]

In a conventional sealant for a dye-sensitized solar cell, there has not been present such a type that has no leak or evaporation of an electrolyte after a reliability test, and is cured upon irradiation of energy rays. It has been known that cracking in the sealant or interfacial peeling between the sealant and a substrate by the reliability test raised critical defect, and ingress of moisture into a cell by a moisture resistance test, or evaporation of an electrolytic solution through the sealant in a test to be exposed at high-temperature or the like results in deterioration of reliability.

[MEANS FOR SOLVING THE PROBLEMS]

A sealant composition for a dye-sensitized solar cell comprising (A) to (D) components.
An (A) component: a hydrogenated polybutadiene compound having a (meth)acrylic group;
A (B) component: a hydrogenated polybutene compound having a kinematic viscosity of 100 to 5000 cSt at 98.9°C;
A (C) component: a (meth) acrylic compound having an alicyclic hydrocarbon; and
A (D) component: a photo initiator.

EP 2 395 596 A1

## Description

### TECHNICAL FIELD

The present invention relates to provision of a composition suitable for sealing an electrolytic solution to be used in a dye-sensitized solar cell, which is cured by irradiation of energy rays.

### BACKGROUND ART

In recent years, the dye-sensitized solar cell (hereinafter, abbreviated as a DSC) based on a Grätzel-type cell, which can be produced in lower cost as compared with a silicon-type solar cell, has attracted attention. A photoelectric conversion efficiency of a commercially available silicon-type solar cell is around 15% in the case of a single crystalline silicon-type and polycrystalline silicon-type, and around 7% in the case of an amorphous silicon-type, while there has been discovered possibility that the DSC may attain the photoelectric conversion efficiency coming close to that of the silicon-type solar cell. Under such circumstances, there is an enterprise who has disclosed a production method for the DSC quickly as in PATENT LITERATURE 1 (JP-A-2002-313443).

Explanation will be given briefly on a structure of the Grätzel-type cell. The nano-size titanium oxide particles in the form of paste are applied to a glass substrate attached with a transparent conductive layer, the substrate is sintered at about 450°C, and the substrate is used as an anode (photoelectrode). On the other hand, the platinum is deposited to a glass substrate attached with a transparent conductive layer, and the substrate is used as a cathode (counter electrode). Then the anode and the cathode are faced each other via the sealant. In the case of a reactive sealant, curing is terminated. After that, an electrolytic solution is poured into a gap formed by the both electrodes and the sealant to produce the dye-sensitized solar cell.

In order to stably produce the DSC having the high photoelectric conversion efficiency, the following three points should be improved. The first improvement is further enhancement of the photoelectric conversion efficiency as a fundamental improvement. Improvement of an electrode, a substrate, a sensitizing dye, and an electrolyte has still been progressing at present. The second improvement is enhancement of cell durability. In the DSC, leakage and evaporation of the electrolyte are serious problems in view of safety. As countermeasures thereto, research on solidification of the electrolyte, or substitution with ionic liquid or gelled electrolyte has also been performed at present. The third improvement is enhancement of mass production efficiency. In the case of use as substitution for the silicon-type solar cell, enhancement of mass production efficiency is indispensable. It has been known to use the sealant in the DSC, aiming at adhesion of the electrode to the substrate, as well as confining the electrolyte. The sealant can be said the most important material in enhancement of cell durability and enhancement of mass production efficiency. There have been known various sealants such as paste (liquid), a sheet, a processed good (solid) and the like.

In view of easy change of application form or high production efficiency, a liquid sealant composition, such as those disclosed in PATENT LITERATURE 2 (JP-A-2006-8819), and PATENT LITERATURE 3 (JP-A-2005-297578, corresponding USP No. 6655277) is suitable for DSC. In particular, a curing method by energy rays such as ultraviolet rays or visible rays has high production efficiency because the curing is completed in a short period. However, a reactive-type sealant has a problem of evaporation or leakage of the electrolyte, or moisture permeation from outside.

However, a sealant composed of only a curable composition provides furious deterioration in the reliability test. Because the DSC is exposed to sunlight, the reliability test is an important test item. As a specific test method for confirming reliability, there has been performed a moisture resistance test for standing still under high temperature and high humidity (for example, at 85°C×85% RH) ; a heat cycle test for repeating standing still at low-temperature and standing still at high-temperature (for example, switching between -40°C and 90°C), or a heat shock test with severer switching condition between low-temperature and high-temperature as compared with the heat cycle test; a test to be exposed at high-temperature (for example, at a constant temperature of 85°C); or a test to be exposed at low-temperature (for example, at a constant temperature of -40°C). In the case of the DSC, cracking in the sealant or interfacial peeling between the sealant and a substrate in the reliability test is critical defect. In addition, it has been known that ingress of moisture into a cell by a moisture resistance test, or evaporation of an electrolytic solution through the sealant in a test to be exposed at high-temperature or the like results in deterioration of reliability. It has been known to give flexibility or softness by adding a rubbery plasticizer as in PATENT LITERATURE 4 (JP-A-2006-12732) in order to enhance reliability. However, it has been known that there is a problem which the composition becomes turbid by non-compatibility at the initial stage, or the plasticizer bleeds out during the reliability test, and that the photoelectric conversion efficiency of the DSC decreases by such phenomena.

## DISCLOSURE OF INVENTION

## PROBLEM TO BE SOLVED BY THE INVENTION

In a conventional sealant for the DSC, there has not been present such a type that has no leak or evaporation of an electrolyte after a reliability test, and is cured upon irradiation of energy rays.

## MEANS FOR SOLVING THE PROBLEM

The present inventors have intensively studied a way to attain the above objects and as a result completed the present invention, a sealant composition composed of a reactive composition having a hydrogenated polybutadiene skeleton and a non-reactive composition of a hydrogenated polybutene structure, which can be cured by energy rays, as well as being endurable even to the reliability test.

Explanation will be given next on gist of the present invention. The first embodiment of the present invention is a sealant composition for a dye-sensitized solar cell composed of (A) to (D) components.

An (A) component: a hydrogenated polybutadiene compound having a (meth)acrylic group;
A (B) component: a hydrogenated polybutene compound having a kinematic viscosity of 100 to 5000 cSt (0.0001~0.005 $m^2/s$) at 98.9°C;
A (C) component: a (meth)acrylic compound having an alicyclic hydrocarbon; and
A (D) component: a photo initiator.
The second embodiment of the present invention is the sealant composition for a dye-sensitized solar cell according to claim 1 (the first embodiment), wherein the content of the (B) component is 20 to 80 parts by mass and the content of the (C) component is 10 to 70 parts by mass, relative to 100 parts by mass of the (A) component.

The third embodiment of the present invention is the sealant composition for a dye-sensitized solar cell according to claim 1 or 2 (the first embodiment or the second embodiment), wherein the (A) component is synthesized from (a-1) to (a-3) components.

The (a-1) component: a hydrogenated polybutadiene compound having two or more hydroxyl groups in a molecule;
The (a-2) component: a compound having two or more isocyanate groups in a molecule; and
The (a-3) component: a (meth)acrylic compound having one hydroxyl group in a molecule.

The fourth embodiment of the present invention is the sealant composition for a dye-sensitized solar cell according to any one of claims 1 to 3 (the first embodiment to the third embodiment), wherein average molecular weight of the (a-1) component is 1000 to 4000.

The fifth embodiment of the present invention is the sealant composition for a dye-sensitized solar cell according to any one of claims 1 to 4 (the first embodiment to the fourth embodiment), wherein the (C) component comprises at least one kind selected from the group consisting of isobornyl (meth)acrylate, dicyclopentenyl (meth)acrylate, dicyclopentenyloxyethyl (meth)acrylate, dicyclopentanyl (meth)acrylate, and 1-adamantyl (meth)acrylate.

## ADVANTAGES OF THE INVENTION

The sealant composition of the present invention is suitable for the DSC composed of a reactive composition having a hydrogenated polybutadiene skeleton and a non-reactive composition of a hydrogenated polybutene structure, which can be cured by energy rays, as well as being endurable even to the reliability test.

## BRIEF DESCRIPTION OF THE DRAWINGS

Fig. 1 is a schematic showing one example of an assembling method for a pseudo DSC test piece prepared by using the sealant composition for a dye-sensitized solar cell of the present invention.
Fig. 2 is a side view schematic showing one example of a pseudo DSC test piece prepared by using the sealant composition for a dye-sensitized solar cell of the present invention.

## DETAILED DESCRIPTION OF THE EMBODIMENT

Hereinafter, explanation will be given in next paragraphs on detail of the present invention, however, the technical range of the present invention should be determined based on description of scope of claim for patent and should not be limited only to the following embodiments. In addition, dimensional ratio of the drawings may be exaggerated

for convenience of explanation, and thus may be different from the practical ratio.

The (A) component which can be used in the present invention is not especially limited, as long as it is a compound having a hydrogenated polybutadiene skeleton represented by the following formula (1), and having an acrylic group or a methacrylic group in a molecule. From the viewpoint of handling, the (A) component is preferably in a liquid state at normal temperature (25°C) under normal pressure. (Hereinafter, an acrylic group and a methacrylic group may be referred to as a (meth) acrylic group together. Similarly, an acrylate and a methacrylate may be referred to as a (meth) acrylate together.)

[FORMULA 1]

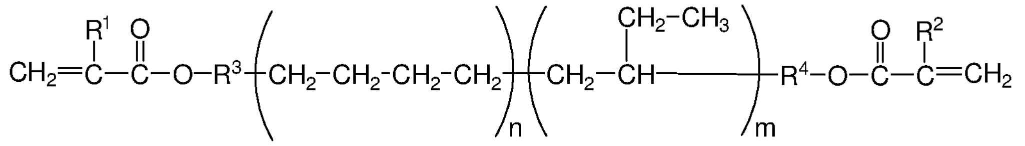

Formula (1)

(In the above formula (1), $R^1$ and $R^2$ each independently represent a hydrogen atom or a methyl group; $R^3$ and $R^4$ each independently represent an organic group of an aliphatic hydrocarbon or an aromatic hydrocarbon containing or not containing an oxygen atom, a nitrogen atom, a sulfur atom, and/or a phosphorous atom; and n and m satisfy n: m=0 to 100:100 to 0.)

Hydrogenation is a reduction reaction to add a hydrogen atom to a compound, using hydrogen gas as a reducing agent, and means to convert an unsaturated bond present in a molecule to a saturated bond.

Ratio of n:m is 0 to 100:100 to 0, and preferably 10 to 15:85 to 90. In addition, the (A) component with n=0, composed of only a structural unit derived from a branched butadiene may also be used preferably.

In addition, in the formula (1), it is preferable that $(CH_2CH_2CH_2CH_2)_n(CH_2CHCH_2CH_3)_m$ has an average molecular weight (weight average) in a range of 1000 to 4000.

In the case where n and m represent average addition mole number of butadiene, it is preferable to be $18 \leq n+m \leq 70$.

Still more, the (A) component is preferably a urethane modified acrylic oligomer having the hydrogenated polybutadiene skeleton.

Specifically, the (A) component is preferable to be synthesized from the (a-1) component (the hydrogenated polybutadiene compound having two or more hydroxyl groups in a molecule), the (a-2) component (the compound having two or more isocyanate groups in a molecule), and the (a-3) component (the (meth)acrylic compound having one hydroxyl group in a molecule). As a specific example of a synthesis method, the hydrogenated polybutadiene having a (meth) acrylic group can be synthesized by reacting a hydroxyl group of (a-1) with an isocyanate group of (a-2) and subsequently reacting a residual isocyanate group of (a-2) with a hydroxyl group of (a-3).

The urethane modified acrylic oligomer having the hydrogenated polybutadiene skeleton can be represented by the following formula (A) or formula (B). It should be noted that the following formulae (A) and (B) are formulae represented schematically by dividing the formula (1). In the formulae (A) and (B), M represents a (meth) acrylic group means $CH_2=CR^{1(2)}$-COO- in the formula (1); and P represents polybutadiene and means $(CH_2CH_2CH_2CH_2)_n(CH_2CHCH_2CH_3)_m$ in the formula (1).

[FORMULA 2] [Formula (A)] M- $(R^5O)_p$-OCNH-X-NHCO-$OR^6$-P-$R^6O$-OCNH-X-NH-CO-$(OR^5)_p$-M

In the above formula (A), $(R^5O)_p$-OCNH-X-NHCO-$OR^6$ corresponds to $R^3$ in the formula (1), and $R^6O$-OCNH-X-NHCO-$(OR^5)_p$ corresponds to $R^4$ in the formula (1).

In the formula (A), $R^5$ is a straight chain or branched chain alkylene group having carbon atoms of 1 to 4; p represents 0 or 1; X contains at least one kind selected from a straight chain, branched chain or cyclic alkylene group having carbon atoms of 2 to 20, and an arylene group having carbon atoms of 6 to 20; and $R^6$ represents a straight chain or branched chain alkylene group having carbon atoms of 4. It should be noted that the arylene group may be in condensation form.

When p is 0 in the above formula, $-(R^5O)_p-$ represents a single bond and when p is 1, it represents $-R^5O-$.

$-R^5O-$ in the formula (A) represents a residual group of the above-described (a-3) component "the (meth)acrylic

compound having one hydroxyl group in a molecule"; $-OR^6$-represents a residual group of the above-described (a-1) component "the hydrogenated polybutadiene compound having two or more hydroxyl groups in a molecule"; and -OCNH-X-NHCO-represents a skeleton derived from the above-described (a-2) component "the compound having two or more isocyanate groups in a molecule".

[FORMULA 3] [Formula (B)] M- ($R^7$-COO) -OCNH-X-NHCO-$OR^6$-P-$R^6$O-OCNH-X-NHCO-(OOC-$R^7$) -M

In the above formula (B), ($R^7$-COO)-OCNH-X-NHCO-$OR^6$ corresponds to $R^3$ in the formula (1), and $R^6$O-OCNH-X-NHCO-(OOC-$R^7$) corresponds to $R^4$ in the formula (1). In addition, ($R^7$-COO) in the formula (B) corresponds to $R^5$ in the formula (A), and $R^6$ and X are common in the formulae (A) and (B).

In the formula (B), $R^7$ contains at least one kind selected from a straight chain, branched chain or cyclic alkylene group having carbon atoms of 1 to 8, and a carboxyl group; and $R^6$ and X are the same as in formula (A).

-$R^7$-COO- in the formula (B) represents a residual group of the above-described (a-3) component "the (meth) acrylic compound having one hydroxyl group in a molecule", and $-OR^6$-represents a residual group of the (a-1) component "the hydrogenated polybutadiene compound having two or more hydroxyl groups in a molecule"; and -OCNH-X-NHCO-represents a skeleton derived from the above-described (a-2) component "the compound having two or more isocyanate groups in a molecule".

In the above formula (B), $R^7$ may be represented preferably as -$R^8$-OOC-$R^{8'}$ -; and $R^8$ and $R^{8'}$ each independently represent a straight chain, branched chain or cyclic alkylene group having carbon atoms of 1 to 8. In addition, more preferably, $R^8$ is a straight chain or branched chain alkylene group having carbon atoms of 1 to 4; and $R^{8'}$ represents a straight chain, branched chain or cyclic alkylene group having carbon atoms of 1 to 8.

As a commercially available (A) component, TEAI-1000, produced by Nippon Soda Co., Ltd. is known.

The (a-1) component is not especially limited, as long as it is the hydrogenated polybutadiene compound having two or more hydroxyl groups in a molecule. In addition, it is preferable that a terminal group of the hydrogenated polybutadiene compound is substituted with a hydroxyl group.

The (a-1) component is not especially limited as long as it is the hydrogenated polybutadiene compound having a hydroxyl group, however, it is preferable that an average molecular weight (weight average) is in a range of 1000 to 4000. In the case where the average molecular weight (weight average) is below 1000, viscosity of the (A) component is too low, resulting in bleeding out of the (B) component from the composition, while in the case where it is over 4000, viscosity is too high, generating a roping in dispensing and rises a problem in dispensing. The average molecular weight can be measured by a gel permeation chromatography (GPC) method, using a tetrahydrofuran as a eluting solvent and using a standard polystyrene as a base by a column polystyrene gel.

The (a-1) component may also be synthesized by a known method, or may be available from a commercial product.

As a specific example of the commercial (a-1) component, GI-1000, GI-2000 and GI-3000, produced by Nippon Soda Co., Ltd., HLBH-P3000 and HLBH-P2000, produced by Sartomer Japan Inc., or the like may be exemplified. Among these, GI-2000 or GI-3000 is preferable. In addition, the (a-1) component may be one kind or a mixture of two or more kinds of the above-described compounds.

The (a-2) component is not especially limited, as long as it is the compound having two or more isocyanate groups in a molecule, and it may be represented as the following formulae (3), (4), (5), (6), (7) or (8).

[FORMULA 4]

$O=C=N-R'-N=C=O$

Formula (3)

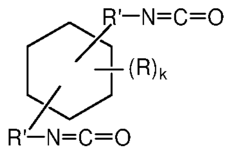

Formula (4)

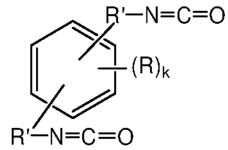

Formula (5)

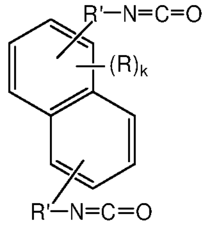

Formula (6)

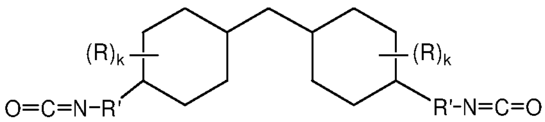

Formula (7)

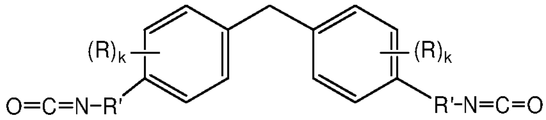

Formula (8)

Wherein R' represents a straight chain or branched chain alkylene group having carbon atoms of 1 to 8; R represents a substitution group of an aromatic ring or cyclohexane, and represents an alkyl group or an alkoxy group with carbon atoms of 1 to 5; and k is 0 to 10.

In the above formulae (3) to (8), R' preferably represents a straight chain or branched chain alkylene group having carbon atoms of 1 to 6.

In the above formulae (3) to (8), k is preferably 0 to 4, and more preferably 0 to 3.

In the compounds represented by the above formulae (3) to (8), a portion excluding the isocyanate group corresponds to X in the formulae (A) and (B).

As a specific example of the (a-2) component, the aromatic diisocyanate includes 2,4-tolylene diisocyanate, 2,6-tolylene diisocyanate, 4,4'-diphenylmethane diisocyanate, 2,4'-diphenylmethane diisocyanate, 2,2'-diphenylmethane diisocyanate, polyphenylene polymethylene polyisocyanate, 1,5-naphthylene diisocyanate, 1,4-naphthylene diisocyanate, p-phenylene diisocyanate, m-phenylene diisocyanate, o-xylylene diisocyanate, or m-xylylene diisocyanate or the like; and the aliphatic diisocyanate includes tetramethylene diisocyanate, hexamethylene diisocyanate, or 2-methyl-1,5-pentane diisocyanate or the like. In addition, the alicyclic diisocyanate includes 1-methylcyclohexane-2,4-diisocyanate, isophorone diisocyanate, dicyclohexylmethane-4,4'-diisocyanate or the like, however, it should not be limited to these. In addition, among these compounds, from the viewpoint of easy availability, a preferable one is the aromatic diisocyanate such as 2,4-tolylene diisocyanate, 2,6-tolylene diisocyanate, 4,4'-diphenylmethane diisocyanate, 2,4'-diphenylmethane diisocyanate, and 2,2'-diphenylmethane diisocyanate; and the alicyclic diisocyanate such as 1-methylcyclohexane-2,4-diisocyanate, isophorone diisocyanate, and a more preferable one is the aromatic diisocyanate such as 2,4-tolylene diisocyanate,2,6-tolylene diisocyanate. In addition, the (a-2) component may be one kind or a mixture of two or more kinds of the above-described compounds.

The (a-3) component is not especially limited, as long as it is the (meth) acrylic compound having one hydroxyl group in a molecule. It should be noted that the hydroxyl group includes also a hydroxyl group of a carboxylic acid.

A specific example of the (a-3) component includes 2-hydroxyethyl (meth)acrylate, 2-hydroxypropyl (meth) acrylate, 4-hydroxybutyl (meth)acrylate, 2-hydroxybutyl (meth)acrylate, (meth)acrylic acid, 2-(meth)acryloyloxyethylsuccinic acid, 2-(meth)acryloyloxyethyl hexahydrophthalic acid, 2-(meth)acryloyloxyethyl-2-hydroxypropyl phthalate, glycerin di(meth)acrylate, or 2-(meth)acryloyloxyethylacid phosphate or the like, however, it is not limited thereto. In addition, among these compounds, from the viewpoint of reactivity, a preferable one is 2-hydroxyethyl (meth)acrylate, 2-hydroxypropyl (meth)acrylate, 4-hydroxybutyl (meth)acrylate, 2-hydroxybutyl (meth)acrylate, and a further preferable one is 2-hydroxyethyl (meth)acrylate, or 2-hydroxypropyl (meth)acrylate. In addition, the (a-3) component may be one kind or a mixture of two or more kinds of the above-described compounds.

A synthesis method for the (A) component using the above-described (a-1), (a-2) and (a-3) components is not especially limited, however, the (A) component can be synthesized as follows. Firstly, by reacting the (a-1) component with the (a-2) component at 50 to 90°C for 1 to 5 hours, the (a-3) component is dropped. After the dropping, they are stirred at 50 to 90°C for 10 to 30 hours and the (A) component can be obtained. In the relevant synthesis method, order of the addition may also be changed, and the (a-2) component may be reacted with the (a-3) component firstly, and then the (a-1) component may be added thereto. In addition, the (A) component can be synthesized using other known methods.

In the present invention, in the case of synthesizing the (A) component, a combination of (a-1), (a-2) and (a-3) is not especially limited, and for example, a combination of (a-1): polybutadiene having an average molecular weight

of 2000 (GI-2000) or an average molecular weight of 3000 (GI-3000), (a-2): 2,4-tolylene diisocyanate, and (a-3): 4-hydroxybutyl acrylate; a combination of (a-1): polybutadiene having an average molecular weight of 2000 (GI-2000) or an average molecular weight of 3000 (GI-3000), (a-2): isophorone diisocyanate, and (a-3): 2-hydroxyethyl acrylate; a combination of (a-1): polybutadiene having an average molecular weight of 2000 (GI-2000) or an average molecular weight of 3000 (GI-3000), (a-2): hexamethylene diisocyanate, and (a-3) : 2-hydroxyethyl acrylate or the like is exemplified. A combination of (a-1): polybutadiene having an average molecular weight of 2000 (GI-2000) or an average molecular weight of 3000 (GI-3000), (a-2): 2,4-tolylene diisocyanate, and (a-3): 4-hydroxybutyl acrylate; and a combination of (a-1): polybutadiene having an average molecular weight of 2000 (GI-2000) or an average molecular weight of 3000 (GI-3000), (a-2): isophorone diisocyanate, and (a-3): 2-hydroxyethyl acrylate are preferable.

The (B) component which can be used in the present invention is not especially limited, as long as it is a hydrogenated polybutene compound having a kinematic viscosity of 100 to 5000 cSt (0.0001 to 0.005 $m^2/s$) at 98.9°C. Specifically, it is a compound having a structure represented by the formula (2). The (A) component and the (C) component, which are reactive compositions, are cross-linked by radical species of the (D) component, however, even after sufficient cross-linking, a hardened material obtained by a reactive composition tends to be hard and/or brittle in the reliability test. Such degradation phenomena cause cracking of the hardened material or peeling at the interface. In order to prevent the degradation, the (B) component, which is a non-reactive composition, is added to decrease temporal change of the hardened material as much as possible. The (B) component corresponds to a component generally called a plasticizer, but, in the present invention, a compound having a limited structure of what is called hydrogenated polybutene, as well as having limited range of viscosity is most suitable for the (B) component. The resistance to the electrolytic solution enhances by the addition of the (B) component.

[FORMULA 5]

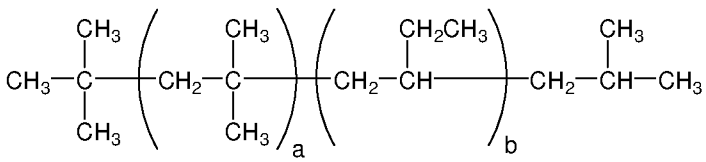

Formula (2)

(wherein a and b satisfy a:b=0 to 100:100 to 0.)

In the formula (2), a and b each independently represent average addition mole number of butylene. In the case where a and b represent average addition mole number of butadiene, they preferably satisfy 9≤a+b≤90, and more preferably 18≤a+b≤70.

In addition, a polyisobutylene compound and a polybutene compound are synthesized using isobutene (other name is isobutylene) as a main raw material, however, the polybutene compound is synthesized by isobutene and 1-butene, and polymerization degree thereof is lower than polyisobutylene. Accordingly, polyisobutylene is sold as a solid or liquid at room temperature, while in the case of polybutene, it is sold as only liquid at room temperature.

In view of easy availability or viscosity, as the (B) component used in the present invention, the one having an average molecular weight (weight average) of 500 to 5000 is preferable, and the one with 1000 to 3000 is more preferable.

It should be noted that, in the present invention, kinematic viscosity of the (B) component can be measured by using a Cannon Fenske viscometer, in accordance with JIS K 2283.

The (B) component may also be synthesized by a known method, or may be available from a commercial product.

The commercially available (B) component includes Idemitsu Polybutene produced by Idemitsu Kosan Co., Ltd.; Nissan Polybutene (Polybis), ParLeam produced by NOF Corporation Co., Ltd.; or the like. In addition, as the (B) component, 300H (produced by Idemitsu Kosan Co., Ltd.), ParLeam 18 (produced by NOF Corporation), ParLeam 24 (produced by NOF Corporation), and ParLeam 46 (produced by NOF Corporation) are preferable.

It is preferable that the (B) component is added in an amount of 20 to 80 parts by mass, relative to 100 parts by mass of the (A) component. The case where the content is less than 20 parts by mass lowers flexibility of a hardened material and makes impossible to endure the reliability test. In addition, in the case where the content is more than 80 parts by mass, the (B) component bleeds out from the hardened material after the initial stage or the reliability test, resulting in tendency to generate the stickiness on surface.

The (C) component in the present invention is a cross-linked cyclic hydrocarbon (alicyclic hydrocarbon) having an acrylate group or an oxyalkylacrylate group as a substitution group, and represented by the following formula (9) or formula (10).

[FORMULA 6]

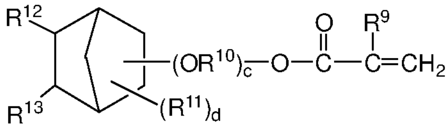

Formula (9)

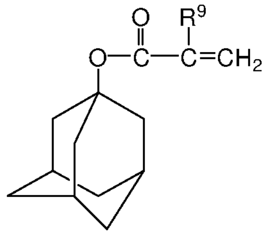

Formula (10)

(wherein $R^9$ is a hydrogen atom or a methyl group; $R^{10}$ represents a straight chain or branched chain alkylene group having carbon atoms of 3 to 7; c is 0 or 1; $R^{11}$ represents a straight chain or branched chain alkyl group having carbon atoms of 1 to 3; d is 0 to 8; $R^{12}$ and $R^{13}$ each independently represent a hydrogen atom or a straight chain or branched chain alkyl group having carbon atoms of 1 to 3; and $R^{12}$ and $R^{13}$ represent substitution groups of cyclohexane and form a ring by bonding)

In the formula (9), when c is 0, $(OR^{10})_c$ represents a single bond, and when c is 1, $-OR^{10}-$ is represented.

In the formula (9), $(R^{11})_d$ represents a substitution group of cyclopentane, and when d is 0, it represents a hydrogen atom, that is, it means a hydrogen of cyclopentane is not substituted by another substitution group.

As a compound represented by the formula (9), the following formulae (11) to (14) are exemplified.

[FORMULA 7]

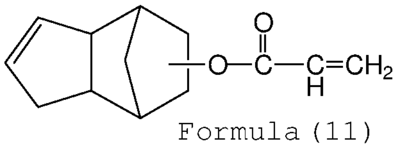

Formula (11)

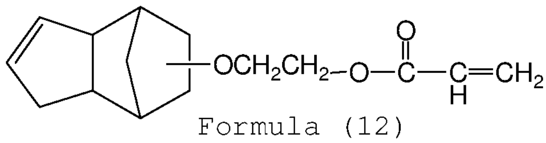

Formula (12)

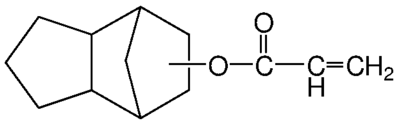

Formula (13)

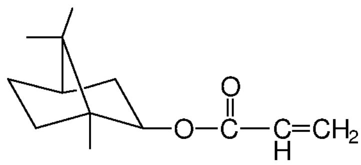

Formula (14)

A specific example of the (C) component, which can be used in the present invention, is not especially limited, as long as it is a meth(acryl) compound having a cross-linked cyclic hydrocarbon (alicyclic hydrocarbon) skeleton in a molecule. A specific example of the (C) component includes isobornyl (meth)acrylate, dicyclopentenyl (meth)acrylate, dicyclopentenyloxyethyl (meth)acrylate, dicyclopentanyl (meth)acrylate, or 1-adamantyl (meth)acrylate or the like. In addition, among these compounds, from the standpoint of compatibility of the (C) component with the (A) component and the (B) component, isobornyl acrylate, dicyclopentenyl acrylate, dicyclopentenyloxyethyl acrylate, dicyclopentanyl acrylate, or 1-adamantyl methacrylate is preferable. In addition, the (C) component may be one kind or a mixture of two or more kinds of the above-described compounds.

Although the causes have not been clarified completely, when a (meth)acrylate having a highly polar hydroxyl group or an amino group, or a highly free straight hydrocarbon group in a molecule was used, the resin composition became turbid, or the (meth) acrylate bleeds out from the hardened material. Because such phenomena were observed, such compound is not suitable for the present invention. In addition, it is included a di-(meth) acrylate having two (meth) acrylic groups in a molecule as a (meth) acrylic compound having an alicyclic hydrocarbon. However, because the compound having the two (meth) acrylic groups has inferior compatibility with the (A) component or/and the (B) component, it cause many troubles such as providing turbidity or generating thixotropy. Therefore, the mono-(meth)acrylate is preferable as the (C) component.

It is preferable that the content of the (C) component is 10 to 70 parts by mass, relative to 100 parts by mass of the (A) component. In addition, it is more preferable that the (C) component is 15 to 60 parts by mass, relative to 100 parts by mass of the (A) component. The content of the (C) component below 10 parts by mass generates a problem in dispensing property due to extremely high viscosity. On the other hand, the addition of more than 70 parts by mass makes the hardened material brittle and generates a problem in the reliability test.

As the (D) component which can be used in the present invention, there have been known a radical-type photo initiator, which generates radical species by energy rays such as visible rays, ultraviolet rays, X rays and electron beams; and a cation-type photo initiator, which generates cation species such as Brønsted acid or Lewis acid. They are added to cross-link the (A) component and the (C) component by radical species and/or cation species generated. It is preferable that the content of the (D) component is 0.1 to 10 parts by weight, relative to 100 parts by weight of the (A) component.

A specific example of the radical-type photo initiator includes acetophenones such as diethoxyacetophenone, 2-hydroxy-2-methyl-1-phenylpropane-1-one, benzyl dimethyl ketal, 4-(2-hydroxyethoxy)phenyl-(2-hydroxy-2-propyl) ketone, 1-hydroxycyclohexyl phenyl ketone, 2-methyl-2-morpholino(4-thiomethylphenyl)propane-1-one, 2-benzyl-2-dimethylamino-1-(4-morpholinophenyl)butanone, and
2-hydroxy-2-methyl-1-[4-(1-methylvinyl)phenyl]propanone oligomer; benzoins such as benzoin, benzoin methyl ether, benzoin ethyl ether, benzoin isopropyl ether, and benzoin isobutyl ether; benzophenones such as benzophenone, methyl o-benzoylbenzoate, 4-phenylbenzophenone, 4-benzoyl-4'-methyldiphenyl sulfide, 3,3',4,4'-tetra(t-butylperoxycarbonyl) benzophenone, 2,4,6-trimethylbenzophenone, 4-benzoyl-N,N-dimethyl-N-[2-(1-oxo-2-propenyloxy)ethyl]b enzenemethanaminium bromide, and (4-benzoylbenzyl)trimethylammonium chloride; and thioxanthones such as 2-isopropylthioxanthone, 4-isopropylthioxanthone, 2,4-diethylthioxanthone, 2,4-dichlorothioxanthone, 1-chloro-4-propoxythioxanthone, and
2-(3-dimethylamino-2-hydroxy)-3,4-dimethyl-9H-thioxantho ne-9-one methochloride, however, it should not be limited to these.

A specific example of the cation-type photo initiator includes a diazonium salt, a sulfonium salt, an iodonium salt or the like, and specifically, includes benzenediazonium hexafluoroantimonate, benzenediazonium hexafluorophosphate, benzenediazonium hexafluoroborate, triphenylsulfonium hexafluoroantimonate, triphenylsulfonium hexafluorophosphate, triphenylsulfonium hexafluoroborate, 4,4'-bis[bis(2-hydroxyethoxyphenyl)sulfonio]phenylsulfid e bishexafluorophosphate, diphenyliodonium hexafluoroantimonate, diphenyliodoniumhexafluorophosphate, and diphenyl-4-thiophenoxyphenylsulfonium hexafluorophosphate or the like, however, it should not be limited to these.

A polymerization inhibitor may be used to maintain storage stability, however, excessive addition amount of the polymerization inhibitor surely enhances storage stability, but on the other hand, impairs reactivity, and thus it is preferable to be used in an amount of 0.001 to 0.1% by mass. A specific example includes the quinone-type polymerization inhibitor such as hydroquinone, methoxyhydroquinone, and benzoquinone, and p-tert-butylcatecol; the alkylphenol-type polymerization inhibitor such as 2,6-di-tert-butylphenol, 2,4-di-tert-butylphenol, 2-tert-butyl-4,6-dimethylphenol, 2,6-di-tert-butyl-4-methylphenol, and 2,4,6-tri-tert-butylphenol; the amine-type polymerization inhibitor such as alkylated diphenylamine, N,N'-diphenyl-p-phenylenediamine, phenothiazine, 4-hydroxy-2,2,6,6-tetramethylpiperidine, 4-benzoyloxy-2,2,6,6-tetramethylpiperidine, 1,4-dihydroxy-2,2,6,6-tetramethylpiperidine, and 1-hydroxy-4-benzoyloxy-2,2,6,6-tetramethylpiperidine; and the N-oxyl-type polymerization inhibitor such as 2,2,6,6-tetramethylpiperidine N-oxyl, 4-hydroxy-2,2,6,6-tetramethylpiperidine N-oxyl, and 4-benzoyloxy-2,2,6,6-tetramethylpiperidine N-oxyl is included, however, it should not be limited to these.

To the sealant composition of the present invention, there may be blended the additives such as a colorant such as pigment or dye; an inorganic filler such as metallic powder, calcium carbonate, talc, silica, amorphous silica, alumina, aluminum hydroxide; a flame retardant, an organic filler, a plasticizer, an antioxidant, an anti-foaming agent, a coupling agent, a leveling agent, or a rheology controlling agent, in a suitable amount in a range not to impair characteristics of the present invention. By adding these, a composition superior in resin strength, bonding strength, workability, storage property or the like, and a hardened material thereof can be obtained.

Suitable applications of the sealant composition of the present invention are not especially limited, however, it is preferable to be applied to the sealant composition for a dye-sensitized solar cell.

The sealant composition of the present invention is the sealant composition suitable for the DSC (dye-sensitized solar cell) composed of a reactive composition having a hydrogenated polybutadiene skeleton and a non-reactive composition of a hydrogenated polybutene structure, which can be cured by energy rays, as well as endurable even to the reliability test.

Other embodiment of the present invention is a dye-sensitized solar cell comprising a sealing part formed by the sealant composition according to claims 1 to 5 (from the first embodiment to the fifth embodiment) of the present invention. By using the sealant composition of the present invention, leakage or evaporation of the electrolyte to be used in the dye-sensitized solar cell can be prevented or suppressed.

EXAMPLES

Explanation will be given next in still more detail on the present invention with reference to EXAMPLES, however, the present invention should not be limited only to these

EXAMPLES.

<Synthesis of a hydrogenated polybutadiene compound having a (meth)acrylic group>

The following components were prepared to produce an acrylic oligomer.
The (a-1) component: the hydrogenated polybutadiene compound having two or more hydroxyl groups in a molecule.

· A hydrogenated polybutadiene compound having an average molecular weight of 2000 and a hydroxyl group value (KOH mg/g) of 40 to 55: "GI-2000, (produced by Nippon Soda Co., Ltd.)"
The (a-2) component: the compound having two or more isocyanate groups in a molecule.
· A mixture of 2,4-tolylene diisocyanate and 2,6-tolylene diisocyanate: "Coronate T-80, (produced by Nippon Polyurethane Industry Co., Ltd.), (mixing ratio: (2,4) type/(2.6) type=80/20)"
The (a-3) component: the (meth)acrylic compound having one hydroxyl group in a molecule.
· 2-hydroxyethyl acrylate: "Light Ester HOA, (produced by Kyoeisha Chemical Co., Ltd.)"

[Synthesis]

103 kg of the (a-1) component and 9.26 kg (53.2 mol) of the (a-2) component were stirred at 60°C for 1 hour. After that, while maintaining at 60°C, 7.66 kg (66.0 mol) of the (a-3) component was gradually dropped. After completion of dropping the whole, stirring was continued for 2 hours, and then warming was stopped to cool naturally to room temperature. After it returns to room temperature, stirring was continued for 24 hours. 119.9 kg of the resultant reaction product was adopted as the (A) component (hereinafter, the (A) component:

the hydrogenated polybutadiene compound having a (meth) acrylic group, obtained in the above step, is referred to as "a synthetic acrylic oligomer"). The synthetic acrylic oligomer is represented by the following formula (15)

[FORMULA 8]

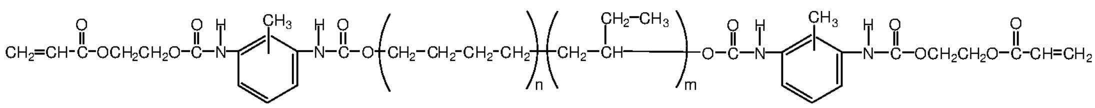

Formula (15)

<Examples 1 to 20>

The following components were prepared to produce the sealant resin composition.
The (A) component: the hydrogenated polybutadiene compound having a (meth)acrylic group

· The synthetic acrylic oligomer (the above formula (15))
· A terminal acrylic modified polybutadiene compound (average molecular weight: 1200): "TEAI-1000 (produced by Nippon Soda Co., Ltd.)" (the above formula (15))
The (B) component: the hydrogenated polybutene compound having a kinematic viscosity of 100 to 5000 cSt (0.0001 to 0.005 $m^2/s$) at 98.9°C
· Hydrogenated polybutene with 850 cSt (0.00085 $m^2/s$) (98.9°C): "300H, (produced by Idemitsu Kosan Co., Ltd.)"
· Hydrogenated polybutene with 300 cSt (0.00030 $m^2/s$) (98.9°C) : "ParLeam 18, (produced by NOF Corporation))" (the formula (16))
· Hydrogenated polybutene with 800 cSt (0.00080 $m^2/s$) (98.9°C): "ParLeam 24, (produced by NOF Corporation)" (the formula (16))

· Hydrogenated polybutene with 4700 cSt (0.0047 $m^2/s$) (98.9°C): "ParLeam 46, (produced by NOF Corporation)" (the formula (16))

[FORMULA 9]

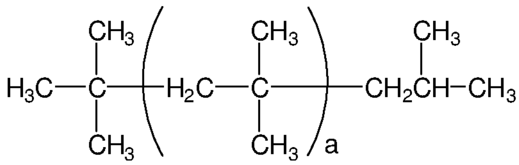

Formula (16)

The (C) component: the (meth)acrylic compound having alicyclic hydrocarbon

· isobornyl acrylate: "Light Acrylate IB-XA, (produced by Kyoeisha Chemical Co., Ltd.)" (formula(14));
· dicyclopentenyl acrylate: "FA-511A, (produced by Hitachi Chemical Co., Ltd.)" (formula (11));
· dicyclopentenyloxyethyl acrylate: "FA-512A, (produced by Hitachi Chemical Co., Ltd.)" (formula (12));
· dicyclopentanyl acrylate: "FA-513A, (produced by Hitachi Chemical Co., Ltd.)" (formula (13));
· 1-adamantyl methacrylate: "ADMA, (produced by Osaka Organic Chemical Industry Ltd.)" (formula (10): $R^9 = CH_3$).

[FORMULA 10]

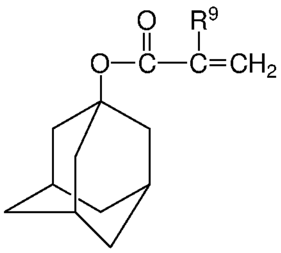

Formula (10)

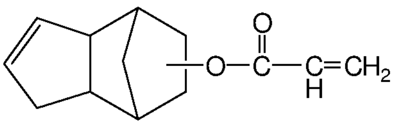

Formula (11)

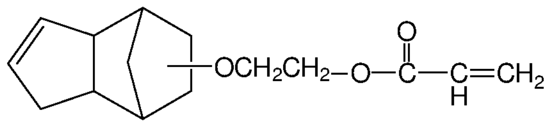

Formula (12)

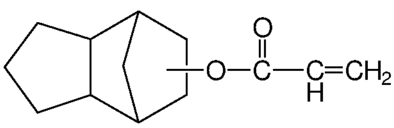

Formula (13)

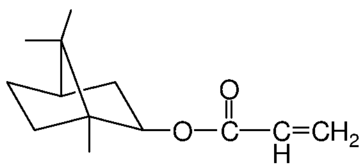

Formula (14)

The (D) component: the photo initiator

· 2-hydroxy-2-methyl-1-phenylpropane-1-one: "DAROCUR 1173, (produced by Chiba Speciality Chemicals Co., Ltd.)"

[Preparation]

The (A) component, the (B) component and the (C) component were stirred for 30 minutes with an agitator. After that, the (D) component was added and further stirred for 30 minutes. Detailed preparation amounts are in accordance with Table 1, where numerical values are all represented by parts by mass.

Table 1

| Raw material name | Example 1 | Example 2 | Example 3 | Example 4 | Example 5 | Example 6 | Example 7 | Example 8 | Example 9 | Example 10 |
|---|---|---|---|---|---|---|---|---|---|---|
| Synthetic acrylic oligomer | 100 | 100 | 100 | 100 | 100 | 100 | 100 | 100 | 100 | 100 |
| TEAI-1000 | | | | | | | | | | |
| 300H | 40 | | | | 20 | 60 | 80 | | | |
| ParLeam 18 | | 40 | | | | | | 20 | 60 | 80 |
| ParLeam 24 | | | 40 | | | | | | | |
| ParLeam 46 | | | | 40 | | | | | | |
| 15H | | | | | | | | | | |
| ParLeam EX | | | | | | | | | | |
| 200N | | | | | | | | | | |
| Glissopal1000 | | | | | | | | | | |
| BI-2000 | | | | | | | | | | |
| LIR-200 | | | | | | | | | | |
| PAO5010 | | | | | | | | | | |
| ARUFON UP-1000 | | | | | | | | | | |
| Diana process oil PS-32 | | | | | | | | | | |
| Light acrylate IB-XA | 30 | 30 | 30 | 30 | 30 | 30 | 30 | 30 | 30 | 30 |
| FA-511A | | | | | | | | | | |
| FA-512A | | | | | | | | | | |
| FA-513A | | | | | | | | | | |
| ADMA | | | | | | | | | | |
| Light acrylate L-A | | | | | | | | | | |
| Light ester HOA | | | | | | | | | | |
| Light acrylate DCP-A | | | | | | | | | | |
| DAROCUR 1173 | 2.6 | 2.6 | 2.6 | 2.6 | 2.6 | 2.6 | 2.6 | 2.6 | 2.6 | 2.6 |
| Total | 172.6 | 172.6 | 172.6 | 172.6 | 152.6 | 192.6 | 212.6 | 152.6 | 192.6 | 212.6 |

| Raw material name | Example 11 | Example 12 | Example 13 | Example 14 | Example 15 | Example 16 | Example 17 | Example 18 | Example 19 | Example 20 |
|---|---|---|---|---|---|---|---|---|---|---|
| Synthetic acrylic oligomer | 100 | | | | | | 100 | 100 | 100 | 100 |
| TEAI-1000 | | 100 | 100 | 100 | 100 | 100 | | | | |
| 300H | | 40 | | | | | | | | |
| ParLeam 18 | | | 40 | | 40 | 40 | 40 | 40 | 40 | 40 |
| ParLeam 24 | 80 | | | 40 | | | | | | |
| ParLeam 46 | | | | | | | | | | |
| 15H | | | | | | | | | | |
| ParLeam EX | | | | | | | | | | |
| 200N | | | | | | | | | | |
| Glissopal1000 | | | | | | | | | | |
| BI-2000 | | | | | | | | | | |
| LIR-20 | | | | | | | | | | |
| PAO5010 | | | | | | | | | | |
| ARUFON UP-1000 | | | | | | | | | | |
| Diana process oil PS-32 | | | | | | | | | | |
| Light acrylate IB-XA | 30 | 30 | 30 | 30 | 15 | 60 | | | | |
| FA-511A | | | | | | | 30 | | | |
| FA-512A | | | | | | | | 30 | | |
| FA-513A | | | | | | | | | 30 | |
| ADMA | | | | | | | | | | 30 |
| Light acrylate L-A | | | | | | | | | | |
| Light ester HOA | | | | | | | | | | |
| Light acrylate DCP-A | | | | | | | | | | |
| DAROCUR 1173 | 2.6 | 2.6 | 2.6 | 2.6 | 2.3 | 3.2 | 2.6 | 2.6 | 2.6 | 2.6 |
| Total | 212.6 | 172.6 | 172.6 | 172.6 | 157.3 | 203.2 | 172.6 | 172.6 | 172.6 | 172.6 |

<Comparative Examples 1 to 13>

The following components were prepared to produce the sealant resin composition.

The (A) component: the hydrogenated polybutadiene compound having a (meth)acrylic group

· The synthetic acrylic oligomer

The (B) component: the hydrogenated polybutene compound having a kinematic viscosity of 100 to 5000 cSt (0.0001~0.005 $m^2/s$) at 98.9°C

· Hydrogenated polybutene with 300 cSt (0.00030 $m^2/s$): "ParLeam 18, (produced by NOF Corporation)"

The (B') component: other compounds (plasticizer)

· Hydrogenated polybutene having a kinetic viscosity of 32 cSt (0.000032$m^2/s$) at 98.9 °C: "15H, (producedby Idemitsu Kosan Co., Ltd.)";

· Hydrogenated polybutene having a kinetic viscosity of 2.5 cSt (0.0000025 $m^2/s$) at 98.9 °C : "ParLeam EX, (produced by NOF Corporation)";

· Polybutene: "200N, (produced by NOF Corporation)";

· Polyisobutylene: "Glissopal 1000, (produced by BASF-JAPAN Ltd.)"

· Hydrogenated polybutadiene: "BI-2000, (produced by Nippon Soda Co., Ltd.)";

· Hydrogenated polyisoprene: "LIR-200, (produced by Kuraray Co., Ltd.)";

· Hydrogenated decene-1 polymer: "PAO 5010, (produced by Idemitsu Kosan Co., Ltd.)";

· Acrylic polymer: "ARUFON UP-1000, (produced by Toagosei Co., Ltd.)";

· Petroleum hydrocarbon: "Diana Process Oil PS-32, (produced by Idemitsu Kosan Co., Ltd.)".

The (C) component: the (meth)acrylic compound having an alicyclic hydrocarbon

· Isobornyl acrylate: "Light Acrylate IB-XA, (produced by Kyoeisha Chemical Co., Ltd.)";

The (C') component: other (meth)acrylic compounds

· Lauryl acrylate: "Light Acrylate L-A, (produced by Kyoeisha Chemical Co., Ltd.)";

· 2-Hydroxyethyl acrylate: "Light Ester HOA, (produced by Kyoeisha Chemical Co., Ltd.)";

· Dimethyloltricyclodecane diacrylate: "Light Acrylate DCP-A, (produced by Kyoeisha Chemical Co., Ltd.)" (the following formula (17)

[FORMULA 11]

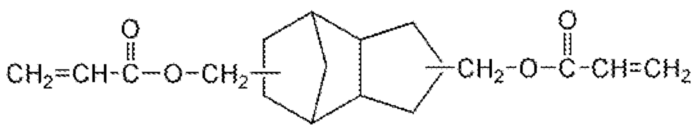

Formula (17)

The (D) component: the photo initiator

· 2-Hydroxy-2-methyl-1-phenylpropane-1-one; "DAROCUR-1173, (produced by Chiba Speciality Chemicals Co., Ltd.)".

[Preparation]

The (A) component, the (B) component and the (C) component were stirred for 30 minutes with an agitator. After that, the (D) component was added and further stirred for 30 minutes. Detailed preparation amounts are in accordance with Table 2, where numerical values are all represented by parts by mass.

Table 2

| Raw material name | Comparative Example 1 | Comparative Example 2 | Comparative Example 3 | Comparative Example 4 | Comparative Example 5 | Comparative Example 6 | Comparative Example 7 |
|---|---|---|---|---|---|---|---|
| Synthetic acrylic oligomer | 100 | 100 | 100 | 100 | 100 | 100 | 100 |
| TEAI-1000 | | | | | | | |
| 300H | | | | | | | |
| ParLeam 18 | | | | | | | |
| ParLeam 24 | | | | | | | |
| ParLeam 46 | | | | | | | |
| 15H | 40 | | | | | | |
| ParLeam EX | | 40 | | | | | |
| 200N | | | 40 | | | | |
| Glissopal1000 | | | | 40 | | | |
| BI-2000 | | | | | 40 | | |
| LIR-200 | | | | | | 40 | |
| PAO5010 | | | | | | | 40 |
| ARUFON UP-1000 | | | | | | | |
| Diana process oil PS-32 | | | | | | | |
| Light acrylate IB-XA | 30 | 30 | 30 | 30 | 30 | 30 | 30 |
| FA-511A | | | | | | | |
| FA-512A | | | | | | | |
| FA-513A | | | | | | | |
| ADMA | | | | | | | |
| Light acrylate L-A | | | | | | | |
| Light ester HOA | | | | | | | |
| Light acrylate DCP-A | | | | | | | |
| DAROCUR 1173 | 2.6 | 2.6 | 2.6 | 2.6 | 2.6 | 2.6 | 2.6 |
| Total | 172.6 | 172.6 | 172.6 | 172.6 | 172.6 | 172.6 | 172.6 |

| Raw material name | Comparative Example 8 | Comparative Example 9 | Comparative Example 10 | Comparative Example 11 | Comparative Example 12 | Comparative Example 13 |
|---|---|---|---|---|---|---|
| Synthetic acrylic oligomer | 100 | 100 | 100 | 100 | 100 | 100 |
| TEAI-1000 | | | | | | |
| 300H | | | | | | |
| ParLeam 18 | | | | 40 | 40 | 40 |
| ParLeam 24 | | | | | | |
| ParLeam 46 | | | | | | |
| 15H | | | | | | |
| ParLeam EX | | | | | | |
| 200N | | | | | | |
| Glissopal1000 | | | | | | |
| BI-2000 | | | | | | |
| LIR-200 | | | | | | |
| PAO5010 | | | | | | |
| ARUFON UP-1000 | 40 | | | | | |
| Diana process oil PS-32 | | 40 | | | | |
| Light acrylate IB-XA | 30 | 30 | 30 | | | |
| FA-511A | | | | | | |
| FA-512A | | | | | | |
| FA-513A | | | | | | |
| ADMA | | | | | | |
| Light acrylate L-A | | | | 30 | | |
| Light ester HOA | | | | | 30 | |
| Light acrylate DCP-A | | | | | | 30 |
| DAROCUR 1173 | 2.6 | 2.6 | 2.6 | 2.6 | 2.6 | 2.6 |
| Total | 172.6 | 172.6 | 132.6 | 172.6 | 172.6 | 172.6 |

On the sealant compositions of Examples 1 to 20, and Comparative Examples 1 to 13, confirmation of compatibility, measurement of viscosity, measurement of hardness, test for moisture permeation rate (a cup method), test

for permeability of electrolytic solution (a wet cup method), test for resistance to electrolytic solution, test for elution property and test for penetration of iodine were performed. Results thereof were summarized in Table 3.

[Confirmation of compatibility]

10 g of the sealant composition was sampled in a glass bottle, which was stood still at an ambient temperature of 25°C for three days. Presence or absence of turbidity of the resin composition was confirmed with visual inspection to judge "compatibility" between the components themselves. The case of "O" shows they are comparable and the composition becomes transparent, while the case of "x" shows they are not comparable and the composition becomes turbid.

[Measurement of viscosity]

After confirming that temperature of the sealant composition has attained room temperature after performing preparation thereof, "viscosity (Pa·s)" was measured under the following conditions. The case of over 200 Pa·s, which is the measurement limitation of the following specifications, is shown as "OL".

Specifications of a viscometer

Manufacturer: TV-33-model viscometer (EHD model), manufactured by Toki Sangyo Co., Ltd.

Measurement condition

Cone rotor: 3°×R14
Rotation speed: 0.5 to 2.5 rpm (Rotation speed is changed depending on viscosity.)
Measurement time: 5 minutes
Measurement temperature: 25°C

[Measurement of hardness]

The sealant composition was poured into a frame of a size of 10 cm×10 cm×3 mm so that bubbles are not mixed in. After that, by irradiation of an integrated light intensity of 3000 mJ/cm$^2$ (30 kJ/m$^2$) using an ultraviolet ray irradiator, two pieces of the sheet-like hardened materials of the sealant composition with a thickness of 3 mm were prepared. "Hardness" was measured with Durometer A by a means for sample, which was made by superimposing two sheets and was of 6 mm thickness. A detailed test method is in accordance with JISK7215.

[Moisture permeation rate test(a cup method)]

The sealant composition was poured into a frame of a size of 200 m×200 m×0.5 mm so that bubbles are not mixed in. After that, by irradiation in an integrated light intensity of 3000 mJ/cm$^2$ (30 kJ/m$^2$) using an ultraviolet ray irradiator, a sheet-like hardened material with a thickness of 0.5 mm was prepared. 5 g of calcium chloride (anhydrous) was put into an aluminum cup having an opening part with a diameter of 30 mm, and the hardened material was set in a cup. After measurement of "initial total mass" (g), the cup was stood still for 24 hours while maintaining at an ambient temperature of 85°C and a relative humidity of 85%. After the cup has returned to room temperature after humidification, "total mass after standing still" (g) was measured to calculate "moisture permeation rate (g/m$^2$·24 h). In the case where the hardened material fractured during the test, it is shown as "NG".

A detailed test method is in accordance with JISK0208. In the present invention, below 200 g/m$^2$·24 h is suitable.

[Preparation of an electrolytic solution]

As a main component of the electrolytic solution, 3-methoxypropionitrile, γ-butyrolactone, propylene carbonate or the like has been known, however, in the present invention, γ-butyrolactone is used. 0.05 mol of iodine, 0.1 mol of lithium iodide, 0.5 mol of 4-tert-butylpyridine, and 0.6 mol of 1,2-dimethyl-3-propylimidazolium iodide were added, based on 1 liter of γ-butyrolactone, and they were stirred until the solution becomes homogeneous (hereinafter, the electrolytic

solution indicates the present electrolytic solution).

[Test for permeability of the electrolytic solution (a wet cup method)]

The sealant composition was poured into a frame of a size of 200 mm×200 mm×0.5 mm so that bubbles are not mixed in. After that, by irradiation of an integrated light intensity of 3000 mJ/$cm^2$ (30 kJ/$m^2$) using an ultraviolet ray irradiator, a sheet-like hardened material with a thickness of 0.5 mm was prepared. This test was performed using the aluminum cup having an opening part with a diameter of 30 mm, which was used in the moisture permeation rate test. 5 g of the electrolytic solution was put in the cup and the hardened material was set. After measurement of "initial total mass" (g), the cup was stood still at an ambient temperature of 85°C for 24 hours. After the cup has returned to room temperature after heating, "total mass after standing still" (g) was measured to calculate "moisture permeation rate" (g/$m^2$·24 h). Major test method is in accordance with JISK0280. In the present invention, below 400 g/$m^2$·24 h is suitable.

[Test for resistance to electrolytic solution]

The sealant composition was poured into a cylinder-type container with a diameter of 20 mm so that bubbles are not mixed in.

After smoothening the surface, by irradiation of an integrated light intensity of 3000 mJ/$cm^2$ (30 kJ/$m^2$) using an ultraviolet ray irradiator, a cylinder-like hardened material was prepared. Two pieces of each hardened material were prepared respectively to weigh "initial mass of the hardened material" (g). The hardened material was put into a glass container filled with the electrolytic solution, and sealed. At this time, the hardened material was in a completely dipped state in the electrolytic solution. The glass container was stood still at an ambient temperature of 60°C for one week. When the glass container was taken out and has returned to room temperature, the hardened material was taken out of the glass container and the electrolytic solution was quickly wiped off, and then "mass of the hardened material after immersion" (g) was measured to calculate "mass change rate" (%) from EXPRESSION 1, which is adopted as "resistance to electrolytic solution". In the present invention, 0 to 10% is suitable.

[EXPRESSION 1]

[Mass change rate (test for resistance to electrolytic solution)] (%)=100 × [(mass of the hardened material after immersion) (g)-(initial mass of the hardened material)(g)]/(initial mass of the hardened material) (g)

[Test for elution property]

The hardened material after completion of "test for resistance to electrolytic solution" was stood still at an ambient temperature of 60°C for 1 day. When the hardened material has returned to room temperature after standing still, "mass of the hardened material after drying" (g) was measured to calculate "mass change rate" (%) from EXPRESSION 2, which was adopted as "elution property". In "test for resistance to electrolytic solution", at the same time when the hardened material absorbs the electrolytic solution, the content of the hardened material may elutes into the electrolytic solution. Accordingly, in the present test, drying was performed at 60°C to remove the electrolytic solution absorbed, and confirmed ratio of the content eluted from the hardened material. In the present invention, -5 to 0% is suitable.

[EXPRESSION 2]

[Mass change rate (elution test)] (%)=100 × [(mass of the hardened material after drying) (g)-(initial mass of the hardened material (test for resistance to electrolytic solution))(g)]/(initial mass of the hardened material (test for resistance to electrolytic solution)) (g)

[Test for penetration of iodine]

Iodine contained in the electrolytic solution adds to an unsaturated group in contacting with a composition having the unsaturated group in a molecular structure. Decrease in iodine concentration in the electrolytic solution may incur decrease in cell performance along it. The present test confirms degree of iodine penetration inside the hardened material. A test piece was prepared as follows:, the composition was applied at the center of glass (30 mm×30 mm×10mm) masked in a region of a width of 10 mm×a length of 30 mm×a thickness of 100 μm to squeegee, and by laminating another piece of glass, the composition was cured by irradiation in an integrated light intensity of 3000 $mJ/cm^2$ (30 $kJ/m^2$) using an ultraviolet ray irradiator. 0.5 gof iodine and said test piece were put into a 150-mL container, and stood still at an ambient atmosphere of 60°C for three days. After taking it out, by washing excess iodine with IPA and drying, the test piece was observed with a CCD camera. Distance of discoloring (dark brown color) from the end part toward the inner part of the composition was measured as "penetration distance of iodine" (mm). Distances at three points were measured to determine an average value thereof. In the present invention, below 0.5 mm is suitable.

Table 3

| Test item | Unit | Example 1 | Example 2 | Example 3 | Example 4 | Example 5 | Example 6 | Example 7 | Example 8 | Example 9 | Example 10 |
|---|---|---|---|---|---|---|---|---|---|---|---|
| Compatibility | - | ○ | ○ | ○ | ○ | ○ | ○ | ○ | ○ | ○ | ○ |
| Viscosity | Pa·s | 65 | 57 | 74 | 112 | 80 | 42 | 30 | 70 | 28 | 28 |
| Hardness | - | 44 | 40 | 33 | 44 | 50 | 32 | 34 | 46 | 36 | 34 |
| Moisture permeation rate (Cup method) | $g/m^2 \cdot 24h$ | 170 | 172 | 161 | 154 | 270 | 138 | 130 | 195 | 142 | 134 |
| Permeability of electrolytic solution (Wet cup method) | $g/m^2 \cdot 24h$ | 370 | 365 | 348 | 251 | 320 | 300 | 310 | 303 | 297 | 290 |
| Resistance to electrolytic solution | % | 5.0 | 5.0 | 5.8 | 6.5 | 5.0 | 3.2 | 2.8 | 6.9 | 3.8 | 2.8 |
| Elution property | % | -2.0 | -2.9 | -1.8 | -1.1 | -1.2 | -2.5 | -3.5 | -1.1 | -3.0 | -3.5 |
| Penetration distance of iodine | mm | 0.42 | 0.44 | 0.40 | 0.36 | 0.46 | 0.40 | 0.39 | 0.45 | 0.39 | 0.39 |

| Test item | Unit | Example 11 | Example 12 | Example 13 | Example 14 | Example 15 | Example 16 | Example 17 | Example 18 | Example 19 | Example 20 |
|---|---|---|---|---|---|---|---|---|---|---|---|
| Compatibility | - | ○ | ○ | ○ | ○ | ○ | ○ | ○ | ○ | ○ | ○ |
| Viscosity | Pa·s | OL | 62 | 52 | 70 | 93 | 5.5 | 26 | 27 | 26 | 108 |
| Hardness | - | 42 | 42 | 40 | 38 | 41 | 44 | 55 | 48 | 45 | 68 |
| Moisture permeation rate (Cup method) | $g/m^2 \cdot 24h$ | 131 | 170 | 175 | 165 | 197 | 194 | 169 | 197 | 192 | 150 |
| Permeability of electrolytic solution (Wet cup method) | $g/m^2 \cdot 24h$ | 280 | 380 | 370 | 345 | 390 | 253 | 384 | 374 | 360 | 312 |
| Resistance to electrolytic solution | % | 3.5 | 5.4 | 5.2 | 5.5 | 4.5 | 6.2 | 5.9 | 5.0 | 5.2 | 5.0 |
| Elution property | % | -2.8 | -1.7 | -1.9 | -1.5 | -2.4 | -1.5 | -2.4 | -2.5 | -2.4 | -1.2 |
| Penetration distance of iodine | mm | 0.40 | 0.42 | 0.44 | 0.40 | 0.44 | 0.42 | 0.46 | 0.48 | 0.42 | 0.42 |

| Test item | Unit | Comparative Example 1 | Comparative Example 2 | Comparative Example 3 | Comparative Example 4 | Comparative Example 5 | Comparative Example 6 | Comparative Example 7 |
|---|---|---|---|---|---|---|---|---|
| Compatibility | - | ○ | ○ | ○ | ○ | ○ | × | ○ |
| Viscosity | Pa·s | 20 | 8 | 73 | 140 | 110 | OL | 32 |
| Hardness | - | 40 | 37 | 38 | 47 | 45 | 41 | 41 |
| Moisture permeation rate (Cup method) | $g/m^2 \cdot 24h$ | NG | NG | 178 | 160 | 185 | 296 | NG |
| Permeability of electrolytic solution (Wet cup method) | $g/m^2 \cdot 24h$ | NG | NG | 316 | 308 | 320 | 446 | NG |
| Resistance to electrolytic solution | % | -10.5 | -13.8 | 5.3 | 6.0 | 5.0 | 7.4 | -12.0 |
| Elution property | % | -20.5 | -22.5 | -2.3 | -1.5 | -1.8 | -0.4 | -23.0 |
| Penetration distance of iodine | mm | 0.42 | 0.40 | 0.80 | 0.84 | 0.62 | 0.55 | 0.52 |

| Test item | Unit | Comparative Example 8 | Comparative Example 9 | Comparative Example 10 | Comparative Example 11 | Comparative Example 12 | Comparative Example 13 |
|---|---|---|---|---|---|---|---|
| Compatibility | - | ○ | ○ | ○ | ○ | × | ○ |
| Viscosity | Pa·s | 52 | 25 | 60 | 8.4 | OL | 30 |
| Hardness | - | 43 | 38 | 53 | 36 | 42 | 49 |
| Moisture permeation rate (Cup method) | $g/m^2 \cdot 24h$ | 520 | NG | 462 | 334 | 303 | 235 |
| Permeability of electrolytic solution (Wet cup method) | $g/m^2 \cdot 24h$ | 390 | NG | 335 | 481 | 538 | 252 |
| Resistance to electrolytic solution | % | 15.0 | -12.0 | 8.1 | 3.9 | 14.5 | 6.1 |
| Elution property | % | -6.0 | -18.0 | -1.1 | -2.5 | -2.5 | -2.0 |
| Penetration distance of iodine | mm | 0.90 | 0.90 | 0.45 | 0.42 | 0.43 | 0.44 |

In the composition of the present invention, resistance to the electrolytic solution is an important characteristics, and test items in Table 3 includes tests of moisture permeation rate (a cup method), test for permeability of electrolytic solution (a wet cup method), test for resistance to electrolytic solution, test for elution property and test for penetration of iodine. The compositions of Examples satisfy all of the numerical values optimal to the present application, whereas compositions of Comparative Examples have the numerical values outside the optimal numerical values.

On Example 1 and Comparative Example 1 in Table 3, and still more on compositions added with various kinds of fillers in Example 1, pseudo DSC test pieces were assembled to perform the reliability test. Detailed preparation amounts are in accordance with Table 4, and numerical values are all shown as parts by mass.

<Examples 21 to 29>

The following components were prepared to produce the sealant composition.

· Amorphus silica powder: (Aerosil R805, produced by Nippon Aerosil Co., Ltd.);
· Spherical silica powder: (FB-5D, produced by Denki Kagaku K.K.);
· Spherical silica powder: (Nipsil SS-50, produced by Tosoh-Silica Corporation);
· Talc powder: (P-3, produced by Nippon Talc Co., Ltd.);
· Calcium carbonate powder: (Calfine 200, produced by Maruo Calcium Co., Ltd.);
· Hollow glass beads powder: (Q-CEL5020, produced by Potters-Ballotini Co., Ltd.);
· Mica powder: (A-11, produced by Yamaguchi Mica Co., Ltd.);
· Silica powder: (Uselex E-2, produced by Tatsumori Ltd.);
· Spherical silica powder: (HS-301, produced by Micron Inc.).

Table 4

| Raw material name | Example 21 | Example 22 | Example 23 | Example 24 | Example 25 | Example 26 | Example 27 | Example 28 | Example 29 |
|---|---|---|---|---|---|---|---|---|---|
| Example 1 | 100 | 100 | 100 | 100 | 100 | 100 | 100 | 100 | 100 |
| R805 | 9.4 | | | | | | | | |
| FB-5D | | 50.0 | | | | | | | |
| Nipsil SS-50 | | | 20.5 | | | | | | |
| P-3 | | | | 26.4 | | | | | |
| Calfine 200 | | | | | 37.6 | | | | |
| Q-CEL 5020 | | | | | | 33.3 | | | |
| A-11 | | | | | | | 16.7 | | |
| Huselex E-2 | | | | | | | | 37.5 | |
| HS-301 | | | | | | | | | 50.0 |
| Total | 109.4 | 150.0 | 120.5 | 126.4 | 137.6 | 133.3 | 116.7 | 137.5 | 150.0 |

[An assembly method for a pseudo DSC test piece]

The pseudo DSC test piece was assembled similarly as in Fig. 1 and Fig. 2. On a glass substrate 1 with a size of 30 mm×30 mm, a composition 2 was dispensed seamlessly in a square shape with a line width of 1mm and a size of 20 mm×20 mm. (Step 1 of Fig. 1) A glass substrate 3 with a size of 30 mm×30 mm having two holes 4 with a diameter of 1 Φ, was laminated on a glass substrate 1 not so as to misalign. A substance laminated with the glass substrate 1 and the glass substrate 3 was irradiated by an integrated light intensity of 3000 $mJ/cm^2$ (30 $kJ/m^2$) to cure the composition 2.

In this time, a space between the glass substrate 1 and the glass substrate 3 was maintained at 30 μm. After that, the electrolytic solution was charged from one side of the holes 4 of the glass substrate 3 to fill the space with the electrolytic solution 5. (Step 2 of Fig. 1) After that, on the two holes 4 of the glass substrate 3, each 40 mg of a composition 6 for hole filling (the same as the composition 2) was applied. (Step 3 of Fig. 1) After that, the composition 6 for hole filling was sandwiched between a composition 7 for hole filling (the same as the glass substrate 1) and the glass substrate 3, and the substrates were laminated not so as to misalign. Lastly, by irradiation of an integrated light intensity of 3000 $mJ/cm^2$ (30 $kJ/m^2$), the composition 6 for hole filling was cured. (Step 4 of Fig. 1) Side view of the pseudo DSC test piece completed was shown in Fig. 2.

[The reliability test of the pseudo DSC test piece]

Unlike the original DSC, the pseudo DSC test piece, which does not have power generation ability but has a similar structure, was assembled to confirm leakage of the electrolytic solution. In general, a heat resistance test, a humidity resistance test, and a heat cycle resistance test are performed, however, because the humidity resistance test is the most stringent test among the three conditions, standing still at 85°C and an RH of 85% was performed on the pseudo DSC test piece. As a confirmation method, after measurement of "initial test piece mass" (g), it was stood still under atmosphere of a temperature of 85°C and an RH of 85%. After taking out the test piece, it was returned to room temperature to measure "test piece mass after the test" (g) to measure "mass change ratio" (%) from "EXPRESSION 3", based on "mass of an electrolytic solution 5" filled (g). This "mass change ratio" corresponds to ratio of leakage of the electrolytic solution during the reliability test. "Mass change ratio" was measured by every 7 days, and measurement was continued to 42 days as the longest case, and results are summarized in Table 5.

[EXPRESSION 3]

[Mass change ratio (reliability test)] (%)=100 × [(Initial test piece mass) (g)-(test piece mass after the test)(g)]/(mass of the electrolytic solution 5) (g)

Table 5

| Elapsed Days | Example 1 | Example 21 | Example 22 | Example 23 | Example 24 | Example 25 | Example 26 | Example 27 | Example 28 | Example 29 | Comparative Example 1 |
|---|---|---|---|---|---|---|---|---|---|---|---|
| Initial | 0 | 0 | 0 | 0 | 0 | 0 | 0 | 0 | 0 | 0 | 0 |
| 7 Days | 7 | 4 | 4 | 3 | 1 | 2 | 0 | 6 | 5 | 5 | 47 |
| 14 Days | 16 | 15 | 10 | 18 | 14 | 17 | 11 | 13 | 11 | 11 | 80 |
| 21 Days | 27 | 22 | 14 | 22 | 19 | 20 | 14 | 20 | 19 | 18 | 92 |
| 28 Days | 37 | 33 | 20 | 35 | 30 | 29 | 18 | 24 | 24 | 24 | 100 |
| 35 Days | 42 | 43 | 32 | 41 | 35 | 36 | 22 | 30 | 29 | 30 | 100 |
| 42 Days | 58 | 51 | 40 | 51 | 43 | 43 | 30 | 39 | 39 | 35 | 100 |

It is understood from Table 5, that there is difference in mass change ratio of electrolytic solution even between Example 1 and Comparative Example 1, as well as, by the addition of filler to Example 1, reliability thereof is still more increased. It is understood that in Example 29, mass change ratio is 1/3 or less, as compared with Comparative Example 1. Therefore, It shows that the addition of the filler is capable of still more enhancing resistance to the electrolytic solution.

INDUSTRIAL APPLICABILITY

The DSC is a solar cell which can be produced in low cost, and has potential to be used in a general purpose way in the future. However, as one of the big problems of the DSC, there was durability of the sealant to seal the electrolytic solution. The present inventors have intensively studied a way to solve the problems, and have completed the sealing material which can be cured with energy rays, as well as is durable even to the reliability test. Because the sealant of the present invention is capable of attaining enhanced production efficiency of the DSC and low price accompanying with it, and further attaining high reliability of the DSC, it gives a foothold for commercialization of the DSC.

It should be noted that the present application is based on Japanese Patent application No. 2009-022085 filed on Feb. 3, 2009, the disclosed content of which is hereby incorporated by reference in its entirety in this application.

DESCRIPTION OF REFERENCE NUMERALS

1 Glass substrate
2 Composition
3 Glass substrate with two holes
4 Hole
5 Electrolytic solution
6 Composition for hole filling
7 Glass substrate for hole filling
8 Hole 4 filled with electrolytic solution

## Claims

**1.** A sealant composition for a dye-sensitized solar cell comprising (A) to (D) components.
An (A) component: a hydrogenated polybutadiene compound having a (meth)acrylic group;
A (B) component: a hydrogenated polybutene compound having a kinematic viscosity of 100 to 5000 cSt at 98.9°C;
A (C) component: a (meth) acrylic compound having an alicyclic hydrocarbon; and
A (D) component: a photo initiator.

**2.** The sealant composition for a dye-sensitized solar cell according to claim 1, wherein the content of the (B) component is 20 to 80 parts by mass and the content of the (C) component is 10 to 70 parts by mass, relative to 100 parts by mass of the (A) component.

**3.** The sealant composition for a dye-sensitized solar cell according to claim 1 or 2, wherein the (A) component is synthesized from (a-1) to (a-3) components.
An (a-1) component: a hydrogenated polybutadiene compound having two or more hydroxyl groups in a molecule;
An (a-2) component: a compound having two or more isocyanate groups in a molecule; and
An (a-3) component: a (meth) acrylic compound having one hydroxyl group in a molecule.

**4.** The sealant composition for a dye-sensitized solar cell according to according to any one of claims 1 to 3, wherein average molecular weight of the (a-1) component is 1000 to 4000.

**5.** The sealant composition for a dye-sensitized solar cell according to according to any one of claims 1 to 4, wherein the (C) component comprises at least one kind selected from the group consisting of isobornyl (meth)acrylate, dicyclopentenyl (meth)acrylate, dicyclopentenyloxyethyl (meth)acrylate, dicyclopentanyl (meth)acrylate, and 1-adamantyl (meth)acrylate.

**6.** A sealant for a dye-sensitized solar cell comprising the composition according to any one of claims 1 to 5.

7. Adye-sensitized solar cell comprising a seal part formed by the sealant according to claim 6.

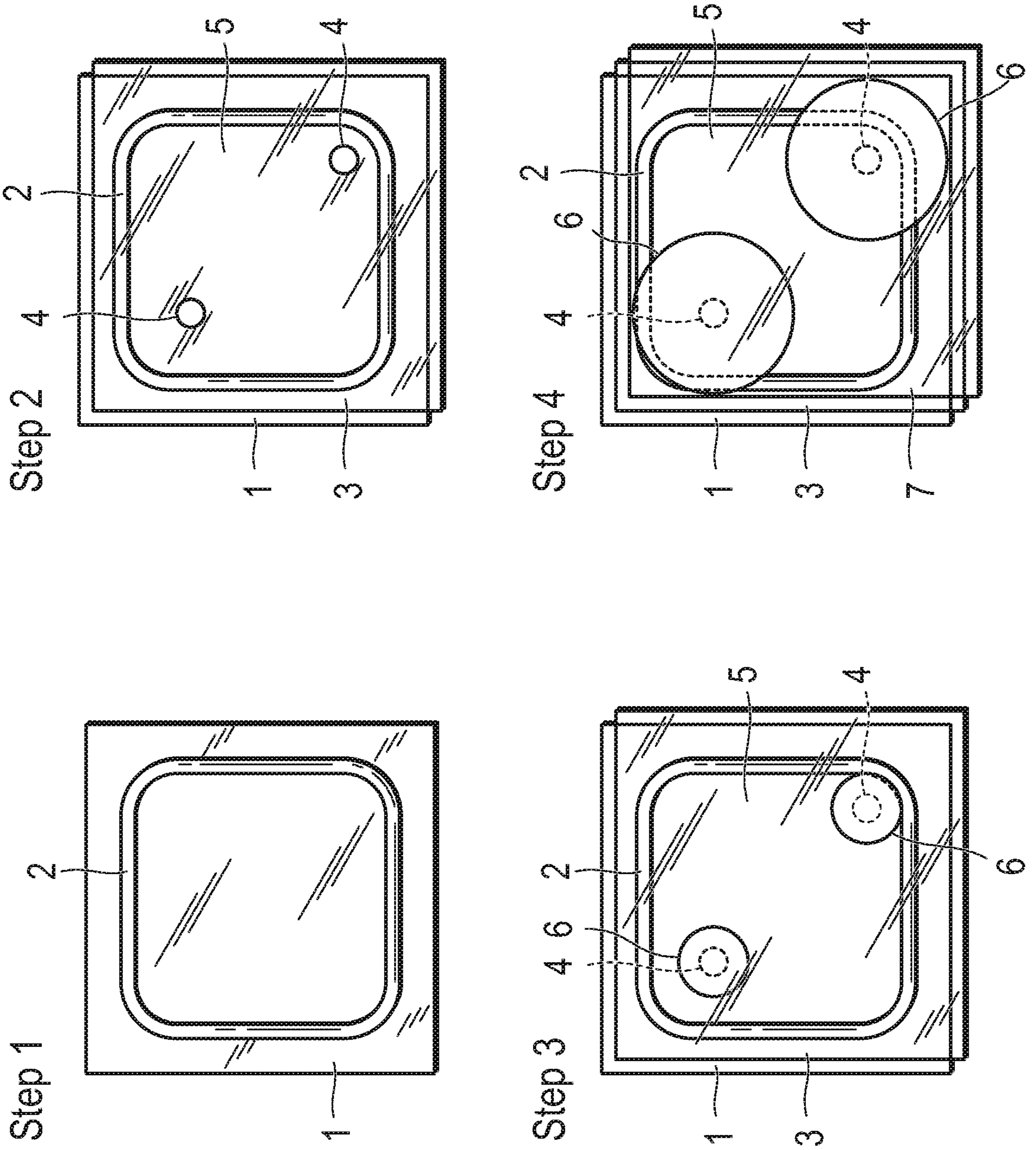


FIG. 1

FIG.2

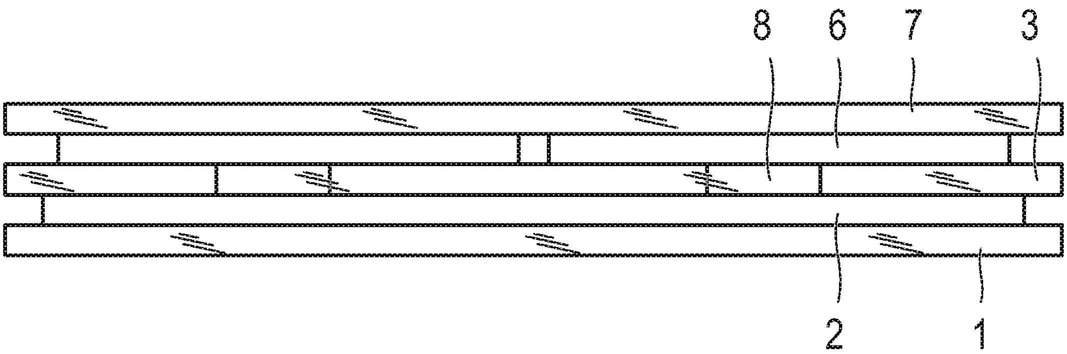

## INTERNATIONAL SEARCH REPORT

International application No.
PCT/JP2010/051268

A. CLASSIFICATION OF SUBJECT MATTER
*H01M14/00*(2006.01)i, *C09K3/10*(2006.01)i, *H01L31/04*(2006.01)i, *H01M2/08*(2006.01)i

According to International Patent Classification (IPC) or to both national classification and IPC

B. FIELDS SEARCHED

Minimum documentation searched (classification system followed by classification symbols)
H01M14/00, C09K3/10, H01L31/04, H01M2/08

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2006-185646 A (Three Bond Co., Ltd.),<br>13 July 2006 (13.07.2006),<br>claims; paragraph [0049]<br>(Family: none) | 1,2,4-7<br>3 |
| Y | WO 2008/056545 A1 (Nitto Denko Corp.),<br>15 May 2008 (15.05.2008),<br>claims<br>& JP 2008-140759 A & AU 2007318720 A1<br>& EP 2099090 A1 & KR 2009-095561 A<br>& CN 101573827 A | 3 |
| A | JP 2005-302564 A (Three Bond Co., Ltd.),<br>27 October 2005 (27.10.2005),<br>(Family: none) | 1-7 |

☐ Further documents are listed in the continuation of Box C.   ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>06 April, 2010 (06.04.10) | Date of mailing of the international search report<br>20 April, 2010 (20.04.10) |
| Name and mailing address of the ISA/<br>Japanese Patent Office<br><br>Facsimile No. | Authorized officer<br><br>Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2002313443 A
- JP 2006008819 A
- JP 2005297578 A
- US 6655277 B
- JP 2006012732 A
- JP 2009022085 A